# EUROPÄISCHE PATENTSCHRIFT

(11) **EP 2 652 962 B1**
(45) Veröffentlichungstag und Bekanntmachung des Hinweises auf die Patenterteilung: **16.08.2017**
(21) Anmeldenummer: 11788122.7
(22) Anmeldetag: 22.11.2011
(51) Int. Cl.: H04Q 9/00, G01R 31/36

(54) **ÜBERWACHUNGS-IC CHIP FÜR BATTERIEMANAGEMENTEINHEIT**
MONITORING IC CHIP FOR BATTERY MANAGEMENT UNIT
PUCE DE CIRCUIT INTÉGRÉ DE CONTRÔLE POUR UNITÉ DE GESTION DE BATTERIE

(30) Priorität: 13.12.2010 DE 102010062872
(43) Veröffentlichungstag der Anmeldung: 23.10.2013
(73) Patentinhaber: Robert Bosch GmbH, 70442 Stuttgart (DE); Samsung SDI Co., Ltd., Yongin-si, Gyeonggi-do 446-577 (KR)
(72) Erfinder: BUTZMANN, Stefan, 71717 Beilstein (DE); THOELMANN, Karsten, 71696 Moeglingen (DE)
(74) Vertreter: Bee, Joachim
(86) Internationale Anmeldenummer: PCT/EP2011/070663
(87) Internationale Veröffentlichungsnummer: WO 2012/079924

(56) Entgegenhaltungen:
- EP-A1- 1 806 592
- EP-A2- 1 933 443
- WO-A1-2008/108979

## Beschreibung

Die vorliegende Erfindung betrifft eine Batterie mit einer Vielzahl von in Reihe geschalteteten Batteriezellen oder Batteriemodulen, welche jeweils eine vorbestimmte Anzahl von Battteriezellen umfasst, und mit einer Batteriemanagementeinheit mit einer Vielzahl von Überwachungs-IC Chips, die dazu ausgebildet sind, mindestens eine Betriebsgröße mindestens einer Batteriezelle oder eines Batteriemoduls, welches eine vorbestimmte Anzahl von Batteriezellen umfasst, zu erfassen, und in einer Daisy-Chain-Topologie an einen ersten Bus derart anschließbar ist, dass sich in der Daisy-Chain-Topologie aufeinander folgende Überwachungs-IC Chips in einer aufsteigenden Spannungskette befinden, wobei einer der an den ersten Bus angeschlossenen Überwachungs-IC Chips als Basis-Überwachungs-IC Chip einsetzbar ist, welcher dazu ausgebildet ist, über einen zweiten Bus mit einem Steuergerät zu kommunizieren, wobei der Überwachungs-IC Chip in Abhängigkeit einer Konfiguration oder einer Beschaltung wahlweise an einem unteren oder an einem oberen Ende der Spannungskette als Basis-Überwachungs-IC Chip eingesetzt ist, wobei jeder der Überwachungs-IC Chips an den ersten Bus angeschlossen ist, und der Basis-Überwachungs-IC Chip ebenfalls an den ersten Bus angeschlossen ist.

### Stand der Technik

Insbesondere in Hybrid- und Elektrofahrzeugen werden heute Batterien in Lithium-Ionen- oder Nickel-Metallhydrid-Technologie eingesetzt, die eine große Anzahl in Serie geschalteter elektrochemischer Batteriezellen aufweisen. Eine Batteriemanagementeinheit wird zur Überwachung der Batterie eingesetzt und soll neben einer Sicherheitsüberwachung eine möglichst hohe Lebensdauer gewähren. Dazu wird die Spannung jeder einzelnen Batteriezelle zusammen mit dem Batteriestrom und der Batterietemperatur gemessen und eine Zustandsschätzung (beispielsweise des Ladezustandes oder des Alterungszustandes der Batterie) vorgenommen. Um die Lebensdauer zu maximieren, ist es hilfreich, jederzeit die aktuell gegebene maximale Leistungsfähigkeit der Batterie, also die maximal abgeb- oder aufnehmbare elektrische Leistung, zu kennen. Wird diese Leistungsfähigkeit überschritten, kann die Alterung der Batterie stark beschleunigt werden.

Um eine genaue Messung der Spannung jeder einzelnen Batteriezelle oder zumindest der Spannung jedes Batteriemoduls, welches eine vorbestimmte Anzahl von Batteriezellen umfasst, zu ermöglichen, sind aus dem Stand der Technik Batteriemanagementeinheiten bekannt, welche eine Vielzahl von hintereinander geschalteten Überwachungs-IC (integrated circuit) Chips umfassen, welche unter anderem Spannungsmessungen ausführen können und in Form einer Daisy-Chain an einen internen Bus angeschlossen sind, welcher eine Kommunikation zwischen den einzelnen Überwachungs-IC Chips ermöglicht, ohne galvanische Trennungen oder den Einsatz von Hochvoltelektronik erforderlich zu machen. Die Überwachungs-IC Chips liegen hierbei mit ihren Versorgungsspannungen, welche von den zu überwachenden Batteriezellen oder Batteriemodulen geliefert werden, in einer Spannungskette und kommunizieren untereinander derart, dass jeder Überwachungs-IC Chip nur mit einem benachbarten Überwachungs-IC Chip kommuniziert und die Kommunikationsdaten, welche von Überwachungs-IC Chips stammen, welche ein höheres Spannungsniveau aufweisen, an den jeweils tiefer im Spannungsniveau liegenden Überwachungs-IC Chip durchreicht. Derartig ausgestaltete Batterien sind beispielsweise in EP 1 806 592 A1, EP 1 933 443 A2 und WO 2008/108979 A1 offenbart.

Am hinsichtlich des Spannungsniveaus tiefst liegenden Ende des Kommunikationsbusses wird ein Basis-Überwachungs-IC Chip angeordnet, welcher ebenfalls an den ersten Kommunikationsbus angeschlossen ist und welcher Nachrichten von jedem der Überwachungs-IC Chips empfangen kann. Außerdem ist der Basis-Überwachungs-IC Chip über einen zweiten Bus mit einem Steuergerät verbunden, welches über diesen die weitergereichten Daten empfängt. Zwischen dem Basis-Überwachungs-IC Chip und dem Steuergerät wird gewöhnlicherweise eine galvanische Trennung vorgenommen.

Die Überwachungs-IC Chips werden gewöhnlich in der Nähe der ihnen zugeordneten Batteriemodule platziert und die Verbindungen für die Kommunikation über den ersten, internen Bus sowie den zweiten, externen Bus durch den Einbau von Kabelbäumen realisiert.

Aus dem Stand der Technik sind IC Chips bekannt, welche nach dem Baukastenprinzip entweder als Basis-Überwachungs-IC Chip am unteren Ende der Spannungskette - also mit einer Schnittstelle zur externen Kommunikation mit dem Steuergerät sowie einer Schnittstelle zu einem weiteren Überwachungs-IC Chip in einer Spannungskette -, oder auch als Überwachungs-IC Chip in der Daisy-Chain konfiguriert werden können.

Wenn die Verkettung in der Daisy-Chain zu lang wird und somit der Datentransfer in der Kommunikation zu lange dauern würde, muss die Verkettung der Überwachungs-IC Chips aufgetrennt werden, wobei zwei oder mehr Basis-Überwachungs-IC Chips eingesetzt werden müssen. Die aus dem Stand der Technik bekannten Bausteine können als Basis-Überwachungs-IC Chip nur am unteren Ende der Spannungskette positioniert werden, was bei Auftrennung der Verkettung eine flexible und an die Geometrie angepasste Anordnung der Bausteine erschwert. Insbesondere wird in bestimmten räumlichen Anordnungen der Einsatz von langen Kabelbäumen erforderlich. Ferner ist bekannt, je einen Basis-Überwachungs-IC Chip an einem unteren und an einem oberen Ende der Spannungskette entlang der Daisy-Chain zu positionieren.

### Offenbarung der Erfindung

Erfindungsgemäß wird eine Batterie bereitgestellt, bei der zwei Daisy-Chains von Überwachungs-IC Chips (also in Form eines integrierten Schaltkreises oder Mikrochips) vorgesehen sind, an einem Ende jeder der Daisy-Chains je ein Basis-Überwachungs-IC Chip angeschlossen ist, wobei einer der beiden Basis-Überwachungs-IC Chips auf einem minimalen Potenzial der Batterie und der andere Basis-Überwachungs-IC Chip auf einem maximalen Potenzial der Batterie liegen.

Die Erfindung ermöglicht es, einen Basis-Überwachungs-IC Chip am oberen oder unteren Ende einer Daisy-Chain-Verkettung zu platzieren. Beim Einsatz von zwei Basis-Überwachungs-IC Chips kann deren Positionierung flexibler vorgenommen werden, und je nach geometrischer Anordnung können dadurch längere Kabelbäume vermieden werden.

Es können zwei Kommunikationsports vorgesehen und einer der Kommunikationsports in Abhängigkeit einer Konfiguration oder einer Beschaltung wahlweise für eine Kommunikation mit einem weiteren gleichartigen Überwachungs-IC Chip oder mit einem Steuergerät einsetzbar sein.

Alternativ können drei Kommunikationsports vorgesehen und einer der Kommunikationsports für eine Kommunikation mit einem Steuergerät einsetzbar sein.

Der Überwachungs-IC Chip kann in einer Mitte der Spannungskette als Basis-Überwachungs-IC Chip einsetzbar sein.

Der Überwachungs-IC Chip kann dazu ausgelegt sein, Nachrichten von einem in der Spannungskette benachbarten Überwachungs-IC Chip an einen anderen in der Spannungskette benachbarten Überwachungs-IC Chip in Abhängigkeit einer Konfiguration oder einer Beschaltung wahlweise in Richtung einer aufsteigenden oder einer absteigenden Spannung durchzureichen.

Ein weiterer Aspekt der Erfindung betrifft eine Batteriemanagementeinheit mit einer Vielzahl von erfindungsgemäßen Überwachungs-IC Chips, wobei jeder der Überwachungs-IC Chips an einen ersten Bus angeschlossen ist, und wobei einer der Überwachungs-IC Chips als Basis-Überwachungs-IC Chip eingesetzt ist, welcher ebenfalls an den ersten Bus angeschlossen und dazu ausgebildet ist, über einen zweiten Bus mit einem Steuergerät zu kommunizieren.

Jeder der Überwachungs-IC Chips kann dazu ausgebildet sein, eine Spannung einer Batteriezelle oder eines Batteriemoduls zu erfassen.

Der Basis-Überwachungs-IC Chip kann an dem ersten Bus als Master konfiguriert und jeder der Überwachungs-IC Chips an dem ersten Bus als Slave konfiguriert sein.

Ein weiterer Aspekt der Erfindung betrifft eine Batterie mit einer Vielzahl von in Reihe geschalteten Batteriezellen oder Batteriemodulen, welche jeweils eine vorbestimmte Anzahl von Batteriezellen umfasst, und mit einer erfindungsgemäßen Batteriemanagementeinheit. Die Batterie ist bevorzugt eine Lithium-Ionen-Batterie.

Es können zwei Daisy-Chains von Überwachungs-IC Chips vorgesehen sein, wobei an einem Ende jeder der Daisy-Chains je ein Basis-Überwachungs-IC Chip angeschlossen ist und wobei einer der beiden Basis-Überwachungs-IC Chips auf einem minimalen Potential der Batterie und der andere Basis-Überwachungs-IC Chip auf einem maximalen Potential der Batterie liegen. Hierbei können die Batteriezellen oder die Batteriemodule derart angeordnet sein, dass sich das minimale und das maximale Potential auf einer Seite der Batterie befinden.

Ein weiterer Aspekt der Erfindung betrifft ein Kraftfahrzeug, insbesondere ein elektrisches Kraftfahrzeug, mit einer erfindungsgemäßen Batterie.

### Zeichnungen

Ausführungsbeispiele der Erfindung werden anhand der Zeichnungen und der nachfolgenden Beschreibung näher erläutert. Es zeigen:
Figur 1 eine Batteriemanagementeinheit nach dem Stand der Technik,
Figur 2 einen Überwachungs-IC Chip gemäß einer ersten Ausführungsform der Erfindung,
Figur 3 einen Überwachungs-IC Chip gemäß einer zweiten Ausführungsform der Erfindung,
Figur 4 und 5 alternative Anordnungen der erfindungsgemäßen Überwachungs-IC Chips in einer Batteriemanagementeinheit und
Figur 6 eine Batterie mit zwei separaten Ketten von Überwachungs-IC Chips.

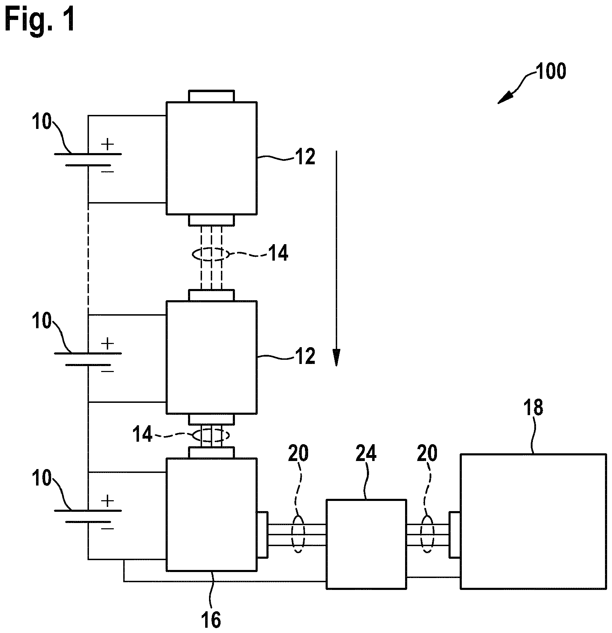

Figur 1 zeigt eine Batteriemanagementeinheit nach dem Stand der Technik, welche Teil einer insgesamt mit 100 bezeichneten Batterie ist. Die Batteriemanagementeinheit umfasst eine Vielzahl von Überwachungs-IC Chips 12, welche in einer Daisy-Chain-Topologie an einen internen Bus 14 angeschlossen sind. Jeder der Überwachungs-IC Chips 12 ist dazu ausgebildet, eine Spannung zu messen, welche an einem ihm zugeordneten Batteriemodul 10 anliegt, wobei ein Batteriemodul 10 eine vorbestimmte Anzahl von Batteriezellen, beispielsweise sechs bis zwölf Batteriezellen, umfasst (in Figur 1 lediglich schematisch dargestellt). Das Batteriemodul 10 kann auch nur eine Batteriezelle umfassen, in welchem Fall der der Batteriezelle zugeordnete Überwachungs-IC Chip 12 die Einzelspannung an der Batteriezelle misst. Die Vielzahl von Batteriemodulen 10 ist in Reihe geschaltet. Jedes Batteriemodul 10 liefert eine Versorgungsspannung an den ihm zugeordneten Überwachungs-IC Chip 12, so dass sich die Vielzahl von Überwachungs-IC Chips 12 in einer aufsteigenden Spannungskette befindet.

Jeder Überwachungs-IC Chip 12 empfängt über den internen Bus 14 Daten von einem ihm gegebenenfalls in der Spannungskette übergeordneten Überwachungs-IC Chip 12 und reicht die empfangenen Daten zusammen mit Daten, welche von ihm selbst erzeugt werden, an den benachbarten Überwachungs-IC Chip 12 durch, welcher in der Spannungskette tiefer gelegen ist. Am unteren Ende der Spannungskette ist ein Basis-Überwachungs-IC Chip 16 angeordnet, welcher alle durchgereichten Daten, die von den Überwachungs-IC Chips 12 stammen, empfängt und über einen externen Bus 20, an den er angeschlossen ist, an ein Steuergerät 18 weiterreicht, welches ebenfalls an den externen Bus 20 angeschlossen ist und ein oder zwei Mikrocontroller umfasst. Jeder Überwachungs-IC Chip 12 ist auf einer eigenen Leiterplatine angeordnet, welche in der Nähe des ihm zugeordneten Batteriemoduls 10 angeordnet ist.

Der interne Bus 14 verwendet ein differentielles Protokoll, welches in Hinblick auf Robustheit und elektromagnetische Verträglichkeit so gewählt ist, dass die Kabel des internen Busses 14 über eine längere Distanz und über mehrere Leiterplatinen hinweg geführt sein können, ohne dass die Kommunikation auf dem internen Bus 14 gestört wird. Hingegen wird auf dem externen Bus 20 ein Busprotokoll verwendet, welches single ended übertragen wird und für eine Kommunikation mit einem Mikrocontroller optimiert ist. Ein solches Protokoll ist in Hinblick auf die elektromagnetische Verträglichkeit störanfälliger und insbesondere nicht dazu ausgelegt, über eine längere Distanz eines Kabels übertragen zu werden. Beispiele hierfür sind ein SPI (Serial Peripheral Interface)-Bus oder ein I²C (Inter-Integrated Circuit)-Bus.

Eine galvanische Trennungseinheit 24 trennt den Basis-Überwachungs-IC Chip 16 und einen ersten Teil des externen Busses 20 einerseits und einen zweiten Teil des externen Busses 20 und das Steuergerät 18 andererseits voneinander. In der galvanischen Trennungseinheit 24 ist außerdem eine Spannungsversorgung des ersten Teils des externen Busses 20 vorgesehen.

Bei der in Figur 1 dargestellten Konfiguration kann der Basis-Überwachungs-IC Chip 16 an dem ersten Bus 14 als Master und jeder der Überwachungs-IC Chips 12 als Slave konfiguriert sein.

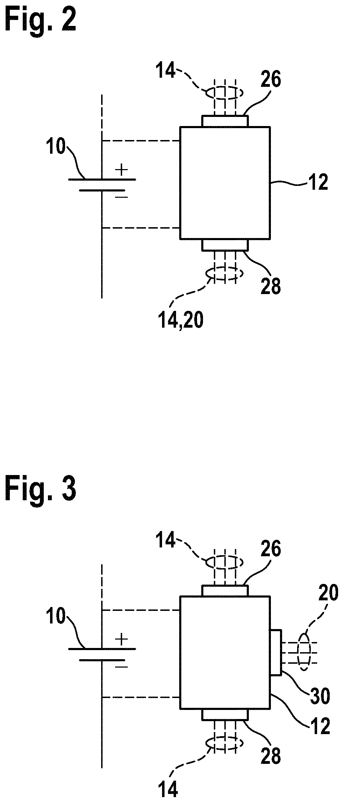

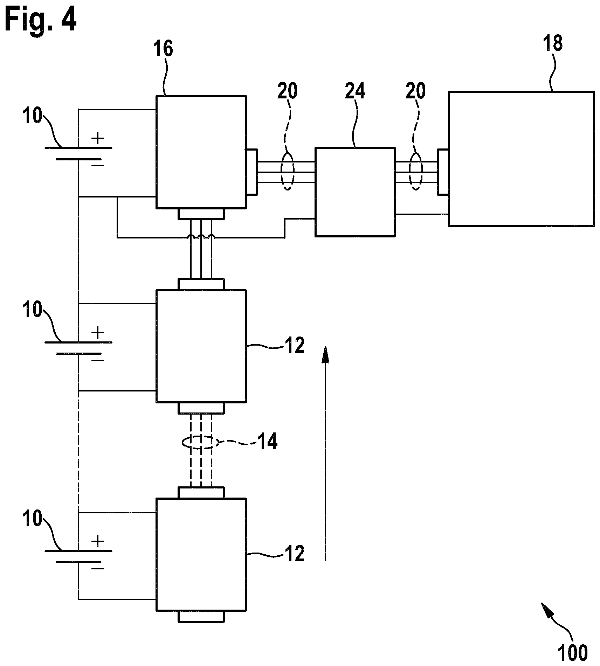

Figur 2 zeigt einen Überwachungs-IC Chip 12 gemäß einer ersten Ausführungsform der Erfindung. Der erfindungsgemäße Überwachungs-IC Chip 12 ist nach dem Baukastenprinzip sowohl als Basis-Überwachungs-IC Chip 16 als auch als einer der übrigen Überwachungs-IC Chips 12 in der in Figur 1 dargestellten Anordnung einsetzbar. Darüber hinaus ist der erfindungsgemäße Überwachungs-IC Chip 12 jedoch auch flexibel in anderen Anordnungen einsetzbar, welche unter anderem in den Figuren 4, 5 und 6 dargestellt sind. Der in Figur 2 dargestellte Überwachungs-IC Chip 12 weist einen ersten Kommunikationsport 26 sowie einen zweiten Kommunikationsport 28 auf. Der erste Kommunikationsport 26 dient in den erwähnten Anordnungen der Kommunikation über den internen Bus 14 mit einem benachbarten, gleichartigen Überwachungs-IC Chip 12, welcher ebenfalls am internen Bus 14 angeschlossen ist (in Figur 2 schematisch dargestellt). Der zweite Kommunikationsport 28 ist wahlweise für eine Kommunikation mit einem weiteren gleichartigen Überwachungs-IC Chip 12 über den internen Bus 14 oder mit einem Steuergerät 18 über den externen Bus 20 einsetzbar. Bei letzterer Wahl übernimmt der Überwachungs-IC Chip 12 die spezielle Funktion eines Basis-Überwachungs-IC Chips 16. Erfindungsgemäß ist vorgesehen, dass hierbei gewählt werden kann, ob er als Basis-Überwachungs-IC Chip 16 an einem unteren oder an einem oberen Ende der Spannungskette einsetzbar ist.

Die Wahl der Kommunikationsform und der Positionierung bezüglich des Spannungsniveaus kann entweder dadurch getroffen werden, dass der Überwachungs-IC Chip 12 als Baustein geeignet konfiguriert wird, zum Beispiel durch Programmierung, oder dadurch, dass er geeignet beschaltet wird. Letzteres heißt, dass der Überwachungs-IC Chip 12 die Verbindungen zu benachbarten Komponenten oder Bussen erfassen kann. Beispielsweise kann der Baustein bei einer Initialisierung feststellen, welche benachbarten Komponenten oder Busse an dem zweiten Kommunikationsport 28 angeschlossen sind, und folgert daraus, mit welchem Busprotokoll über den Kommunikationsport 28 kommuniziert werden soll.

Der Überwachungs-IC Chip 12 ist außerdem dazu ausgelegt, Nachrichten von einem in der Spannungskette benachbarten Überwachungs-IC Chip 12 an einen anderen in der Spannungskette benachbarten Überwachungs-IC Chip 12 wahlweise in Richtung einer aufsteigenden oder einer absteigenden Spannung durchzureichen. Somit muss ein mitten in der Spannungskette angeordneter Überwachungs-IC Chip 12 nicht notwendigerweise Kommunikationsdaten in Richtung des minimalen Potentials weiterreichen, wie dies in der in Figur 1 dargestellten Anordnung der Fall ist, sondern kann sie auch in einer umgekehrten Richtung weiterreichen. Auch hier kann die Wahl der Richtung der Kommunikation entweder dadurch getroffen werden, dass der Überwachungs-IC Chip 12 als Baustein geeignet konfiguriert wird, zum Beispiel durch Programmierung, oder dadurch, dass er geeignet beschaltet wird und die Verbindungen zu benachbarten Komponenten oder Bussen erfassen kann. Beispielsweise kann der Baustein bei einer Initialisierung feststellen, ob der Basis-Überwachungs-IC Chip 16, an welchen Kommunikationsdaten gesendet werden sollen, oberhalb oder unterhalb in der Spannungskette angeordnet ist.

Figur 3 zeigt einen Überwachungs-IC Chip 12 gemäß einer zweiten Ausführungsform der Erfindung. Dieser unterscheidet sich von dem in Figur 2 dargestellten Überwachungs-IC Chip 12 dadurch, dass er neben den ersten beiden Kommunikationsports 26, 28 einen dritten Kommunikationsport 30 aufweist. Die beiden ersten Kommunikationsports 26, 28 dienen jeweils der Kommunikation über den internen Bus 14 mit einem benachbarten, gleichartigen Überwachungs-IC Chip 12, welcher ebenfalls am internen Bus 14 angeschlossen ist. Der dritte Kommunikationsport 28 dient dagegen einer Kommunikation mit einem Steuergerät 18 über den externen Bus 20.

Welche der Kommunikationsports 26, 28, 30 benutzt werden, ist von der im konkreten Fall gewählten Anordnung der Bausteine abhängig. In den meisten Fällen wird hierbei mindestens einer der Kommunikationsports 26, 28, 30 nicht beschaltet sein, so dass entsprechende Pins der Bausteine ungenutzt bleiben. Die Wahl der Belegung der Kommunikationsports 26, 28, 30 kann wie in der ersten Ausführungsform der Erfindung dadurch getroffen werden, dass der einzelne Überwachungs-IC Chip 12 geeignet konfiguriert wird, zum Beispiel durch Programmierung, oder dadurch, dass er geeignet beschaltet wird.

Der Überwachungs-IC Chip 12 gemäß der zweiten Ausführungsform ist analog zur ersten Ausführungsform dazu ausgelegt, die spezielle Funktion eines Basis-Überwachungs-IC Chips 16 an einem unteren oder an einem oberen Ende der Spannungskette zu übernehmen. Außerdem ist er dazu ausgelegt, Nachrichten von einem in der Spannungskette benachbarten Überwachungs-IC Chip 12 an einen anderen in der Spannungskette benachbarten Überwachungs-IC Chip 12 wahlweise in Richtung einer aufsteigenden oder einer absteigenden Spannung durchzureichen.

Welche der Richtungen gewählt wird, ist wiederum von der im konkreten Fall gewählten Anordnung der Bausteine abhängig.

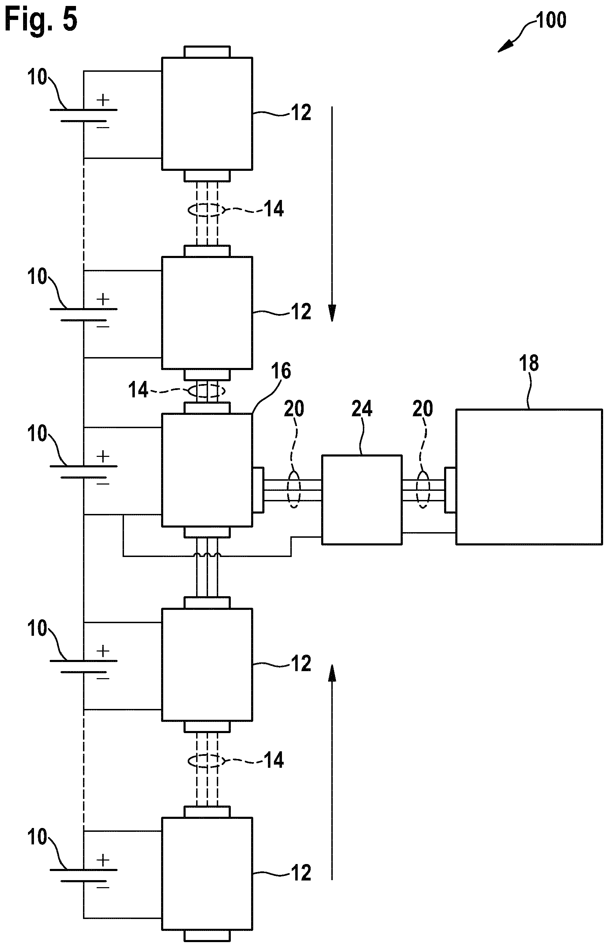

Figuren 4 und 5 zeigen Anordnungen, in welchen der erfindungsgemäße Überwachungs-IC Chip 12 zusätzlich zu der in Figur 1 dargestellten Anordnung nach dem Baukastenprinzip eingesetzt werden kann.

Die in Figur 4 dargestellte Anordnung unterscheidet sich von der in Figur 1 dargestellten darin, dass der als Basis-Überwachungs-IC Chip 16 eingesetzte Baustein, welcher alle durchgereichten Daten, die von den Überwachungs-IC Chips 12 stammen, empfängt und über den externen Bus 20 an das Steuergerät 18 weiterreicht, an einem oberen Ende der Spannungskette angeordnet ist. Jeder der übrigen Überwachungs-IC Chips 12 empfängt über den internen Bus 14 Daten von einem gegebenenfalls in der Spannungskette tiefer gelegenen Überwachungs-IC Chip 12 und reicht die empfangenen Daten zusammen mit Daten, welche von ihm selbst erzeugt werden, an den benachbarten Überwachungs-IC Chip 12 durch, welcher in der Spannungskette höher gelegen ist.

Die in Figur 5 gezeigte Anordnung stellt eine Mischung der in den Figuren 1 und 4 gezeigten Anordnungen dar. Der als Basis-Überwachungs-IC Chip 16 eingesetzte Baustein ist in einer Mitte der Spannungskette angeordnet. Dies kann nur durch einen Baustein gemäß der zweiten Ausführungsform der Erfindung realisiert werden, da hierzu drei Kommunikationsports erforderlich sind. Jeder der übrigen Überwachungs-IC Chips 12 kommuniziert je nach seiner Position in der Anordnung in Richtung einer aufsteigenden oder einer absteigenden Spannung, wie dies in Figur 5 durch Pfeile angedeutet ist. Eine Kommunikation ist in dieser Anordnung im Mittel schneller als in den Anordnungen der Figuren 1 und 4, da sie über weniger Bausteine erfolgt.

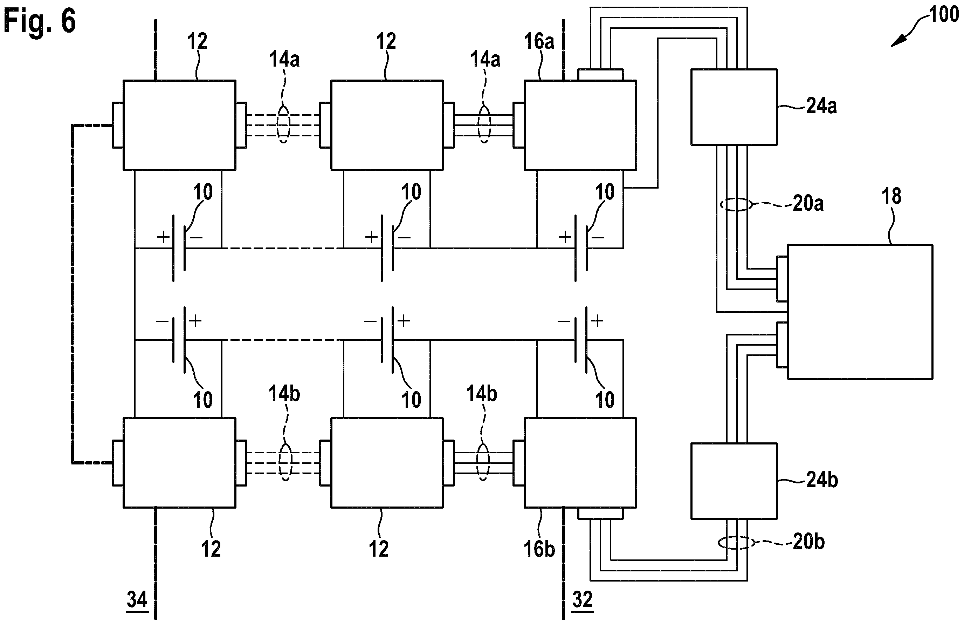

Figur 6 zeigt eine Batterie 100, in welcher die Batteriemodule 10 in Reihe geschaltet sind und derart hufeisenförmig angeordnet sind, dass sich das minimale und das maximale Potential auf einer ersten Seite 32 der Batterie befinden, auf welcher auch das Steuergerät 18 angeordnet ist. Wenn nur ein Strang von Überwachungs-IC Chips 12 vorgesehen wäre, müsste ein Teil des dazugehörigen internen Busses an einer gegenüberliegenden zweiten Seite 34 der Batterie angeordnet sein (in Figur 6 angedeutet durch eine gestrichelte Linie), was zu erhöhter Störanfälligkeit des Bussystems führen würde. Außerdem könnte der Datentransfer in der Kommunikation bei einer zu weit gestreckten Daisy-Chain zu lange dauern. Aus diesem Grund wird die Verkettung der Überwachungs-IC Chips 12 aufgetrennt, und es werden zwei interne Busse 14a, b parallel zueinander angeordnet. Spiegelsymmetrisch werden zwei erfindungsgemäße Überwachungs-IC Chips als benachbarte Basis-Überwachungs-IC Chips 16a, b eingesetzt, welche beide auf der ersten Seite 32 angeordnet sind und wobei einer der beiden Basis-Überwachungs-IC Chips 16a auf einem minimalen Potential der Batterie und der andere Basis-Überwachungs-IC Chip 16b auf einem maximalen Potential der Batterie liegt. Durch diese Anordnung der beiden Basis-Überwachungs-IC Chips 16a, b in unmittelbarer Nähe des Steuergeräts 18 kann die erforderliche Länge von externen Bussen 20a, b, welche die beiden Basis-Überwachungs-IC Chips 16a, b und das Steuergerät 18 verbinden, reduziert werden.

## Patentansprüche

1. Batterie (100) mit einer Vielzahl von in Reihe geschalteten Batteriezellen oder Batteriemodulen (10), welche jeweils eine vorbestimmte Anzahl von Batteriezellen umfasst, und mit einer Batteriemanagementeinheit mit einer Vielzahl von Überwachungs-IC Chips (12), die dazu ausgebildet sind, mindestens eine Betriebsgröße mindestens einer Batteriezelle oder eines Batteriemoduls (10), welches eine vorbestimmte Anzahl von Batteriezellen umfasst, zu erfassen, und in einer Daisy-Chain-Topologie an einen ersten Bus (14) derart anschließbar ist, dass sich in der Daisy-Chain-Topologie aufeinanderfolgende Überwachungs-IC Chips (12) in einer aufsteigenden Spannungskette befinden, wobei einer der an den ersten Bus (14) angeschlossenen Überwachungs-IC Chips (12) als Basis-Überwachungs-IC Chip (16) einsetzbar ist, welcher dazu ausgebildet ist, über einen zweiten Bus (20) mit einem Steuergerät (18) zu kommunizieren, wobei der Überwachungs-IC Chip (16) in Abhängigkeit einer Konfiguration oder einer Beschaltung wahlweise an einem unteren oder an einem oberen Ende der Spannungskette als Basis-Überwachungs-IC Chip (16) einsetzbar ist, wobei jeder der Überwachungs-IC Chips (12) an den ersten Bus (14) angeschlossen ist, und der Basis-Überwachungs-IC Chip (16) ebenfalls an den ersten Bus (14) angeschlossen ist, daduch gekennzeichnet, dass zwei Daisy-Chains von Überwachungs-IC Chips (12) vorgesehen sind, an einem Ende jeder der Daisy-Chains je ein Basis-Überwachungs-IC Chip (16) angeschlossen ist, wobei einer der beiden Basis-Überwachungs-IC Chips (16) auf einem minimalen Potenzial der Batterie und der andere Basis-Überwachungs-IC Chip (16) auf einem maximalen Potenzial der Batterie liegen.

2. Batterie (100) nach Anspruch 1, wobei die Batteriezellen oder die Batteriemodule (10) derart angeordnet sind, dass sich das minimale und das maximale Potenzial auf einer Seite der Batterie befinden.

3. Batterie (100) nach Anspruch 1, wobei zwei Kommunikationsports vorgesehen sind und einer der Kommunikationsports in Abhängigkeit einer Konfiguration oder einer Beschaltung wahlweise für eine Kommunikation mit einem weiteren gleichartigen Überwachungs-IC Chip (12) oder mit einem Steuergerät (18) einsetzbar ist.

4. Batterie (100) nach Anspruch 1, wobei drei Kommunikationsports vorgesehen sind und einer der Kommunikationsports für eine Kommunikation mit einem Steuergerät (18) einsetzbar ist.

5. Batterie (100) nach Anspruch 4, wobei der Überwachungs-IC Chip (12) in einer Mitte der Spannungskette als Basis-Überwachungs-IC Chip (16) einsetzbar ist.

6. Batterie (100) nach einem der Ansprüche 3 bis 5, wobei der Überwachungs-IC Chip (12) dazu ausgelegt ist, Nachrichten von einem in der Spannungskette benachbarten Überwachungs-IC Chip (12) an einen anderen in der Spannungskette benachbarten Überwachungs-IC Chip (12) in Abhängigkeit einer Konfiguration oder einer Beschaltung wahlweise in Richtung einer aufsteigenden oder einer absteigenden Spannung durchzureichen.

7. Batterie (100) nach Anspruch 1, wobei jeder der Überwachungs-IC Chips (12) dazu ausgebildet ist, eine Spannung einer Batteriezelle oder eines Batteriemoduls (10) zu erfassen.

8. Batterie (100) nach Anspruch 1 oder 7, wobei der Basis-Überwachungs-IC Chip (16) an dem ersten Bus (14) als Master konfiguriert ist und wobei jeder der Überwachungs-IC Chips (12) an dem ersten Bus (14) als Slave konfiguriert ist.

9. Kraftfahrzeug, insbesondere elektrisches Kraftfahrzeug, umfassend eine Batterie nach Anspruch 2.

## Claims

1. Battery (100) comprising a multiplicity of series-connected battery cells or battery modules (10), each of which comprises a predetermined number of battery cells, and comprising a battery management unit comprising a multiplicity of monitoring IC chips (12) which are configured to detect at least one operating variable of at least one battery cell or of a battery module (10) which comprises a predetermined number of battery cells, and is connectable to a first bus (14) in a daisy chain topology in such a way that monitoring IC chips (12) succeeding one another in the daisy chain topology are situated in an ascending voltage chain, wherein one of the monitoring IC chips (12) connected to the first bus (14) is useable as a basic monitoring IC chip (16) configured to communicate with a control device (18) via a second bus (20), wherein the monitoring IC chip (12) is useable as a basic monitoring IC chip (16) depending on a configuration or a circuitry optionally at a lower or at an upper end of the voltage chain, wherein each of the monitoring IC chips (12) is connected to the first bus (14), and the basic monitoring IC chip (16) is likewise connected to the first bus (14), **characterized in that** two daisy chains of monitoring IC chips (12) are provided, a respective basic monitoring IC chip (16) being connected at an end of each of the daisy chains, wherein one of the two basic monitoring IC chips (16) is at a minimum potential of the battery and the other basic monitoring IC chip (16) is at a maximum potential of the battery.

2. Battery (100) according to Claim 1, wherein the battery cells or the battery modules (10) are arranged in such a way that the minimum and maximum potentials are situated on one side of the battery.

3. Battery (100) according to Claim 1, wherein two communication ports are provided and one of the communication ports is useable depending on a configuration or a circuitry optionally for a communication with a further monitoring IC chip (12) of identical type or with a control device (18).

4. Battery (100) according to Claim 1, wherein three communication ports are provided and one of the communication ports is useable for a communication with a control device (18).

5. Battery (100) according to Claim 4, wherein the monitoring IC chip (12) in a centre of the voltage chain is useable as a basic monitoring IC chip (16).

6. Battery (100) according to any of Claims 3 to 5, wherein the monitoring IC chip (12) is designed to pass through messages from one monitoring IC chip (12) adjacent in the voltage chain to another monitoring IC chip (12) adjacent in the voltage chain depending on a configuration or a circuitry optionally in the direction of an ascending or a descending voltage.

7. Battery (100) according to Claim 1, wherein each of the monitoring IC chips (12) is configured to detect a voltage of a battery cell or of a battery module (10).

8. Battery (100) according to Claim 1 or 7, wherein the basic monitoring IC chip (16) is configured as master at the first bus (14), and wherein each of the monitoring IC chips (12) is configured as slave at the first bus (14).

9. Motor vehicle, in particular electric motor vehicle, comprising a battery according to Claim 2.

## Revendications

1. Batterie (100) comprenant une pluralité de cellules de batterie branchées en série ou de modules de batterie (10), qui comportent respectivement un nombre prédéfini de cellules de batterie, et comprenant une unité de gestion de batterie comprenant une pluralité de puces de CI de surveillance (12) qui sont configurées pour détecter au moins une grandeur de fonctionnement d'au moins une cellule de batterie ou d'un module de batterie (10), qui comporte un nombre prédéfini de cellules de batterie, et peuvent être raccordées en une topologie en guirlande à un premier bus (14) de telle sorte que des puces de CI de surveillance (12) qui se suivent dans la topologie en guirlande se trouvent dans une chaîne de tension croissante, l'une des puces de CI de surveillance (12) raccordées au premier bus (14) pouvant être utilisée comme puce de CI de surveillance de base (16), laquelle est configurée pour communiquer avec un contrôleur (18) par le biais d'un deuxième bus (20), la puce de CI de surveillance (12) pouvant au choix, en fonction d'une configuration ou d'une connexion, être utilisée au niveau d'une extrémité inférieure ou supérieure de la chaîne de tension en tant que puce de CI de surveillance de base (16), chacune des puces de CI de surveillance (12) étant raccordée au premier bus (14) et la puce de CI de surveillance de base (16) étant également raccordée au premier bus (14), **caractérisée en ce que** deux guirlandes de puces de CI de surveillance (12) sont présentes, une puce de CI de surveillance de base (16) est respectivement raccordée à une extrémité de chacune des guirlandes, l'une des deux puces de CI de surveillance de base (16) se trouvant à un potentiel minimal de la batterie et l'autre puce de CI de surveillance de base (16) à un potentiel maximal de la batterie.

2. Batterie (100) selon la revendication 1, les cellules de batterie ou les modules de batterie (10) étant disposés de telle sorte que le potentiel minimal et le potentiel maximal se trouvent d'un côté de la batterie.

3. Batterie (100) selon la revendication 1, deux ports de communication étant présents et l'un des ports de communication pouvant au choix, en fonction d'une configuration ou d'une connexion, être utilisé pour une communication avec une puce de CI de surveillance (12) supplémentaire identique ou avec un contrôleur (18).

4. Batterie (100) selon la revendication 1, trois ports de communication étant présents et l'un des ports de communication pouvant être utilisé pour une communication avec un contrôleur (18).

5. Batterie (100) selon la revendication 4, la puce de CI de surveillance (12) pouvant être utilisée en un centre de la chaîne de tension en tant que puce de CI de surveillance de base (16).

6. Batterie (100) selon l'une des revendications 3 à 5, la puce de CI de surveillance (12) étant conçue pour faire passer des messages d'une puce de CI de surveillance (12) voisine dans la chaîne de tension vers une autre puce de CI de surveillance (12) voisine dans la chaîne de tension au choix, en fonction d'une configuration ou d'une connexion, dans le sens d'une tension croissante ou d'une tension décroissante.

7. Batterie (100) selon la revendication 1, chacune des puces de CI de surveillance (12) étant configurée pour détecter une tension d'une cellule de batterie ou d'un module de batterie (10).

8. Batterie (100) selon la revendication 1 ou 7, la puce de CI de surveillance de base (16) sur le premier bus (14) étant configurée en tant que maître et chacune des puces de CI de surveillance (12) sur le premier bus (14) étant configurée en tant qu'esclave.

9. Véhicule automobile, notamment véhicule automobile électrique, comprenant une batterie selon la revendication 2.
